# FASCICULE DE BREVET EUROPEEN

(11) **EP 0 374 001 B1**
(45) Date de publication et mention de la délivrance du brevet: **08.09.1993**
(21) Numéro de dépôt: 89403359.6
(22) Date de dépôt: 05.12.1989
(51) Int. Cl.: H01L 23/552, H01L 23/556

(54) **Procédé de durcissement vis-à-vis des rayonnements ionisants de composants électroniques actifs, et composants durcis de grandes dimensions**
Härtungsverfahren gegen ionisierende Strahlung für aktive elektronische Bausteine und gehärtete grosse Bausteine
Hardening process against ionizing radiation for active electronic components, and large hardened components

(30) Priorité: 09.12.1988 FR 8816212
(43) Date de publication de la demande: 20.06.1990
(73) Titulaire: THOMSON-CSF, 75008 Paris (FR)
(72) Inventeur: Mercandalli, Louis, F-92045 Paris la Défense (FR); Pribat, Didier, F-92045 Paris la Défense (FR); Dessertenne, Bernard, F-92045 Paris la Défense (FR); Karapiperis, Leonidas, F-92045 Paris la Défense (FR); Dieumegard, Dominique, F-92045 Paris la Défense (FR)
(74) Mandataire: Chaverneff, Vladimir

(56) Documents cités:
- EP-A- 0 021 643
- EP-A- 0 099 570
- EP-A- 0 115 035
- WO-A-87/00689
- PATENT ABSTRACTS OF JAPAN, vol. 9, no. 295 (E-360)[2018], 21 novebre 1985;& JP-A-60 134 448
- APPLIED PHYSICS LETTERS, vol. 42, no. 6, 15 mars 1983, pages 501-503, American Institute of Physics, New York, US; I. GOLECKI et al.: "Heteroepitaxial Si films on yttria-stabilized, cubic zicronia substrates"

## Description

L'invention se rapporte à un procédé de durcissement vis-à-vis des rayonnements ionisants de composants électroniques actifs, et à des composants durcis fabriqués sur des substrats de grandes dimensions, en particulier des composants du type CMOS ou bipolaires.

L'interaction rayonnement-matière se ramène schématiquement à deux types d'effets : (i) les déplacements d'atomes dus aux phénomènes collisionnels avec les particules chargées ou non (protons, particules alpha, électrons, neutrons, etc...) et (ii) les phénomènes d'ionisation dus a l'absorbtion du rayonnement électromagnétique (rayons γ et x). Ces deux effets sont susceptibles de causer des dommages transitoires ou cumulatifs sur des composants électroniques.

Ainsi, sous l'action du champ électrique régnant dans une jonction ou dans un isolant polarisé, les deux populations de porteurs créés par l'irradiation (porteurs photogénérés) sont séparées, ce qui empêche leur recombinaison immédiate.

Au niveau des matériaux et circuits semiconducteurs, cet effet de séparation de paires électrons-trous photogénérées se traduit par l'apparition de photo-courants qui induisent des phénomènes parasites. Ainsi, le "Single Event Upset" (SEU), c'est-à-dire le changement accidentel occasionnel et localisé d'un niveau logique ; ainsi, encore "l'Upset", c'est-à-dire le changement accidentel mais non localisé d'un niveau logique lié à la propagation dans le circuit des perturbations initiées par les radiations ; ainsi enfin le phénomène de "Latch-up", c'est-à-dire l'amorçage d'un cheminement parasite pn pn qui s'auto-entretient dans les dispositifs CMOS sur substrat de silicium massif.

Au niveau des isolants (particulièrement de la silice), les effets d'ionisation se traduisent essentiellement par un piégeage des trous photogénérés. En effet, la mobllité des trous dans Si0₂ étant plus faible de quelque cinq ordres de grandeur que celle des électrons, lors d'une irradiation transitoire, ces derniers sont balayés par le champ électrique, tandis que les premiers, du fait de leur faible mobilité, restent piégés. Il s'ensuit pour les composants du type MOS une accumulation de charges fixes dans l'oxyde de grille qui induit une dérive de la tension de seuil ainsi que des phénomènes de claquage lorsque cet oxyde de grille est très mince.

D'autre part, l'accumulation de charges fixes dans les oxydes de champ peut aussi induire un phénomène de conduction superficielle (inversion ou accumulation du semiconducteur sous-jacent) qui a pour effet de court-circuiter des composants voisins.

Diverses solutions ont été trouvées pour remédier aux inconvénients cités ci-dessus. Ces solutions (solutions de durcissement) s'appuient d'une part sur des modifications au niveau de la conception des circuits et d'autre part sur des modifications au niveau de la technologie de réalisation de ces circuits.

Ainsi, en rajoutant dans le schéma de la cellule de base d'une mémoire RAM un couple de résistances croisées, on augmente la constante de temps RC de cette cellule de façon telle que les effets transitoires associés aux "Single Event Upset" aient disparu avant que la cellule n'ait eu le temps de basculer (voir par exemple Andrews et Coll. IEEE Transactions on Nuclear Science, Vol.NS-29, Décembre 1982).

Sur le plan de la technologie, on réduit le volume de toutes les zones où règnent des champs électriques (l'épaisseur des oxydes de grille, les dimensions du puits p dans les composants CMOS, etc...), on installe des anneaux de garde pour éviter la formation du chemin parasitique donnant naissance à l'effet de latch-up, etc... (Voir par exemple Ansell et Tirado, dans VLSI Systems Design, Septembre 1986, p. 28).

Cependant, les technologies les plus appréciées pour l'élimination des jonctions d'isolement et de l'effet de "latch-up" reposent sur l'utilisation de couches minces de silicium sur substrats isolants ou SOI (de l'anglais "Silicon On Insulator"). On élimine ainsi de facto le chemin parasitique passant par le substrat semiconducteur et de plus, comme l'isolement entre composants est effectué par gravure, on supprime aussi outre les jonctions d'isolement, un certain nombre d'étapes technologiques d'oxydation, de gravure, et de diffusion ou d'implantation ionique qui sont autant d'opérations épargnées lors de la fabrication d'un composant ou d'un circuit.

Le plus répandu des systèmes SOI est le composite SOS (de l'anglais "Silicon On Sapphire") qui se présente sous la forme d'une couche mince de silicium monocristallin hétéroépitaxié sur une variété monocristalline de l'alumine, à savoir le saphir.

Récemment cependant, d'autres systèmes SOI ont vu le jour, en particulier le système SIMOX (pour "Silicon isolated by IMplanted OXygen") qui consiste en une couche mince de silicium monocristallin séparée du substrat aussi en silicium monocristallin par une couche de silice Si0₂ obtenue par implantation ionique d'une très forte dose d'oxygène dans le substrat de départ (pour plus de détails, voir par exemple Cullen éditeur, "Special Issue of the Journal of Crystal Growth" 63, 3,1983). On connaît aussi le système S D B (pour "Silicon Direct Bonding") qui consiste a coller face à face deux plaquettes de sllicium oxydées et à amincir ensuite l'une d'entre elles, de façon à ramener le silicium à une couche d'épaisseur voisine du micron (voir W.A. Krull et Coll. IEEE Circuits and Devices Mag. July 20,2987 ; voir aussi J. Onura et Coll. IEEE Electron. Device Lett. EDL 8/10,454,1987).

D'autre part, dans le domaine des hétéroépitaxies, on a aussi vu apparaitre récemment des substrats monocristallins différents du saphir et en particulier la zircone yttriée (YZS pour "Yttria-Stabilized Zirconia") qui présente sur le saphir ce premier avantage d'être de structure cubique comme le silicium (voir par exemple Golecki et Coll., Applied Physics Letters, 42,501,1983).

Les zircones stabilisées à l'oxyde d'yttrium présentent aussi sur le saphir ce second avantage d'être de bien moins bons photoconducteurs sous irradiation intense.

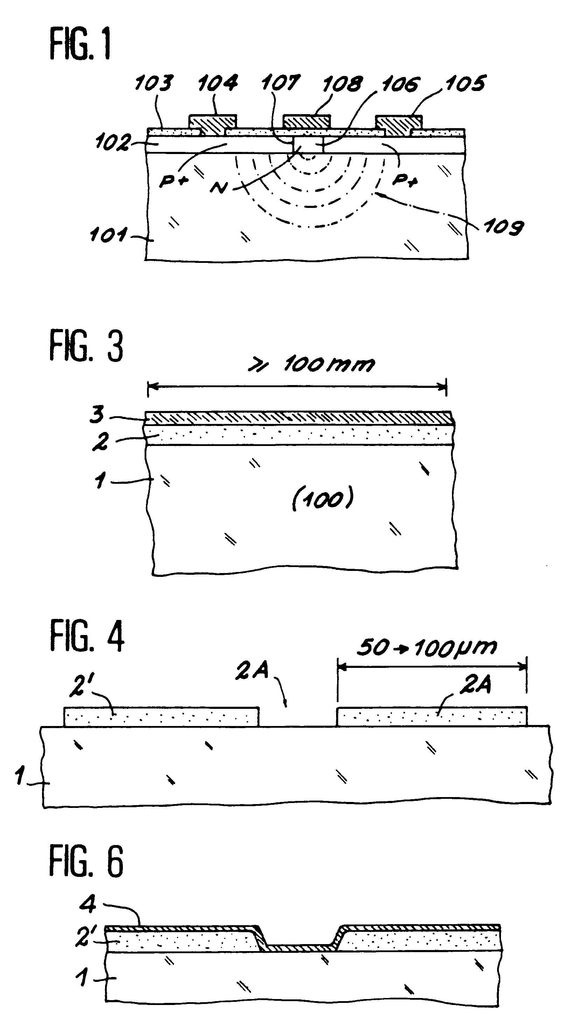

En effet, si l'on se reporte à la figure 1, on constate que lors d'une irradiation d'un composant MOS-SOS, il apparaît entre source et drain un chemin de photoconduction à travers le substrat de saphir, qui a pour effet de court-circuiter le canal du transistor MOS fabriqué sur ce substrat.

Toutefois, si l'on considère les valeurs comparées des produits µ. δ dans différents substrats (où µ est la mobilité des porteurs photogénérés exprimée en cm² V ⁻¹s -¹ et δ leur durée de vie en secondes) on constate que la zircone yttriée est beaucoup moins sujette au phénomène de photoconduction sous irradiation que ne l'est le saphir. Ainsi, dans des conditions de faible injection (irradiations de l'ordre de 100 rad (Si) s⁻¹) µ.δ est de l'ordre de 3 10⁻⁸ cm² V ⁻¹ dans la zircone yttriée, à comparer a 2 10⁻⁷ cm² V ⁻¹ dans le saphir alors que dans des conditions de forte injection (irradiations de 6 10¹⁰ rad (Si) s⁻¹) µ.δ est de l'ordre de 5 10⁻¹²cm² V ⁻¹ dans la zircone yttriée à comparer à 10⁻⁹ dans le saphir (voir Dupont-Nivet et Coll. Abstract N. 134, 173^{rd} Meeting of the Electrochemical Society, Atlanta, Georgia, May 15-20, 1988).

D'autre part, au niveau des dommages permanents, les charges en mouvement sous irradition dans le substrat en saphir restent piégées lorsque les effets d'irradiation s'estomptent. Ce piégeage près de l'interface saphir/silicium est susceptible d'induire des modifications de la conductivité de fond de canal (inversion ou accumulation dans le semiconducteur) qui se traduisent par l'apparition d'un court-circuit permanent entre la source et le drain du transistor MOS considéré. Ainsi il a été montré récemment sur des transistors MOS de type n (cas où le courant de fuite de fond de canal est le plus sensible aux rayonnements ionisants) après une irradiation correspondant à une dose absorbée de 1 Mégarad, le courant de fuite de fond de canal était de 1 nA par micron de largeur de grille pour la structure Si/YSZ alors qu'il était de 100 nA par micron de largeur de grille pour la structure Si/Saphir (voir par exemple Dupont-Nivet et Coll. 173^{rd} Meeting of the Electrochemical Society, Atlanta, Georgia, May 15-20, 1988).

En résumé donc, la zircone yttriée apparaît comme un substrat idéal pour la fabrication de composants électroniques durcis. Le principal inconvénient de ce matériau est que son point de fusion est très élevé (de l'ordre de 2700°C variant légèrement avec la teneur en oxyde d'yttrium et à comparer à 2053°C pour le saphir), ce qui rend pratiquement impossible le tirage de monocristaux de grandes dimensions par des méthodes industrielles telles que la méthode Czochralsky ou la méthode EFG (Edge-defined Film-fed Growth method).

Seuls sont disponibles sur le marché des cristaux (obtenus par refroidissement en auto creuset ou Skull Melting) permettant d'obtenir des plaquettes (100) d'un diamètre maximum de 50 mm (à comparer aux plaquettes de saphir ou de SIMOX de 100 mm et plus).

La présente invention a pour objet un procédé de fabrication de composants MOS ou bipolaires permettant de rendre négligeables les effets précités des rayonnements ionisants, effets qui sont particulièrement sensibles sur les circuits et composants de type MOS et qui consistent essentiellement en la création de paires électrons-trous. L'avantage essentiel de l'invention repose sur la possibilité de fabriquer ces composants sur des substrats de grands diamètres, c'est-à-dire 100mm et plus.

La présente invention a également pour objet une structure de base de composants MOS ou bipolaires, durcis vis-à-vis des rayonnements ionisants, ces composants étant fabriqués sur un substrat ayant un diamètre pouvant être d'au moins 100 mm.

Le procédé de l'invention pour la réalisation de structures de base de tels composants, est caractérisé par la formation sur un substrat en silicium monocristallin ayant des dimensions pouvant dépasser 100 mm, d'une couche de zircone yttriée cette couche étant recouverte d'une couche de silicium monocristallin obtenue par recristallisation par collage ou par germination.

La structure de base de composant MOS conforme à l'invention comporte successivement un substrat en silicium, une couche de zircone yttriée résistant aux effets des rayonnements ionisants, et une couche de silicium au moins partiellement monocristallin.

Ainsi, l'invention permet d'isoler, au moyen d'un matériau très peu photoconducteur, les composants actifs fabriqués dans les régions superficielles d'un substrat qui s'avère en général être photoconducteur (semiconducteur ou isolant) ; l'invention permet ainsi d'augmenter l'immunité de ces composants vis-à-vis des photocourants générés dans le substrat sous irradiation intense.

La présente invention sera mieux comprise à la lecture de la description détaillée de plusieurs modes de réalisation, pris comme exemples non limitatifs et illustrés par le dessin annexé sur lequel :
- la figure 1, déjà citée ci-dessus est une vue schématique en coupe d'un composant MOS-SOS de l'art antérieur,
- la figure 2, déjà citée ci-dessus est un diagramme du courant de fuite de fond de canal d'un composant à structure Si/YSZ de l'art antérieur,
- la figure 3 est une vue en coupe simplifiée d'une structure de base de composant conforme à l'invention,
- les figures 4 et 6 à 8, sont des coupes schématiques illustrant les étapes successives du procédé de l'invention permettant l'obtention d'une couche de silicium de la structure de base par recristallisation ou par germination,
- la figure 5 est un diagramme permettant de déterminer les conditions de dépôt d'une couche de silicium amorphe représentée en figure 6,
- les figures 9 et 10 illustrant deux possibilités différentes d'obtention d'une couche mince de silicium monocristallin pour la structure de base, et
- les figures 11A et 11B à 15 sont des vues en coupe simplifiées illustrant plusieurs variantes conformes à l'invention du procédé de collage.

On va décrire ci-dessous plusieurs possibilités de mise en oeuvre du procédé de l'invention permettant de réaliser des composants, discrets ou intégrés, du type MOS (CMOS, MOS-SOS, etc) ou bipolaires. On ne décrira ci-dessous que les étapes de réalisation de la structure de base de ces composants, c'est-à-dire le substrat et les premières couches déposées sur ce substrat, là où se produisent les effets d'ionisation précités. Les autres couches de ces composants (visibles en figure 1) sont réalisées de façon habituelle, et ne seront donc pas décrites ici.

La structure de base de l'invention, représentée de façon simplifiée en figure 3, comporte successivement un substrat 1 en silicium monocristallin, une couche 2 de zircone stabilisée, et une couche 3 de silicium monocristallin. Le substrat 1 peut être de grandes dimensions : s'il est rond, son diamètre peut être d'au moins 100 mm environ. Toutefois, il est bien entendu que l'invention n'est pas limitée aux substrats de grandes dimensions, et que des dimensions inférieures à 100 mm en font partie. Dans l'exemple de réalisation préféré, la couche 2 est en zircone stabilisée non nécessairement monocristalline, mais tout matériau présentant un produit µ. δ (défini ci-dessus) inférieur à 5.10⁻⁸ environ sous n'importe quelle condition d'irradiation entre dans le cadre de l'invention. L'épaisseur de la couche 2 est avantageusement d'environ 1 micromètre. La couche 3, en silicium monocristallin a avantageusement une épaisseur inférieure à 1 micromètre. Cette couche 3 peut être obtenue, comme expliqué ci-dessous, par recristallisation, épitaxie latérale forcée, ou par collage.

On va d'abord décrire les étapes A1 à A7 permettant d'obtenir la couche 3 de silicium monocristallin par recristallisation ou par germination.

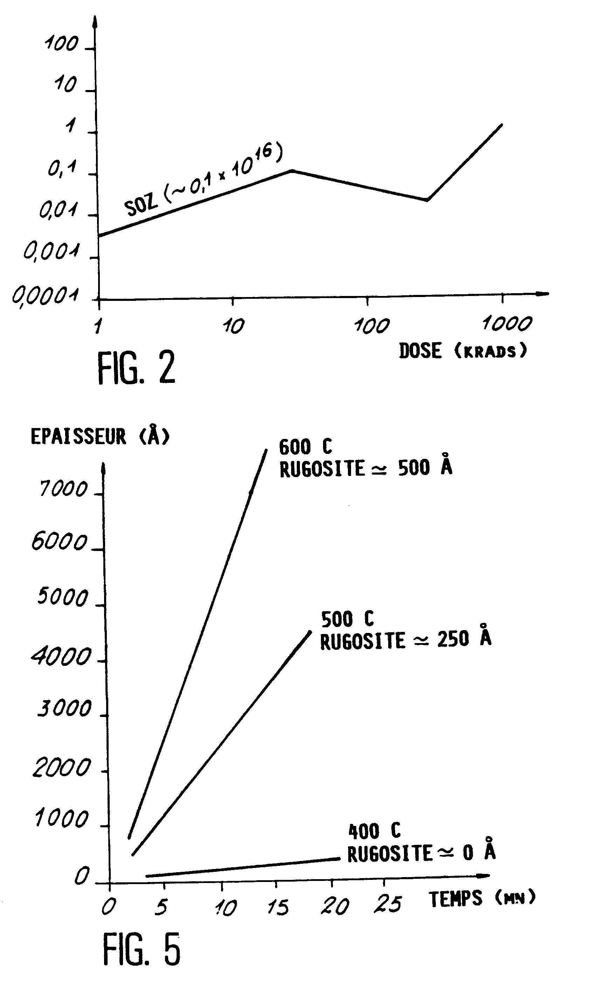

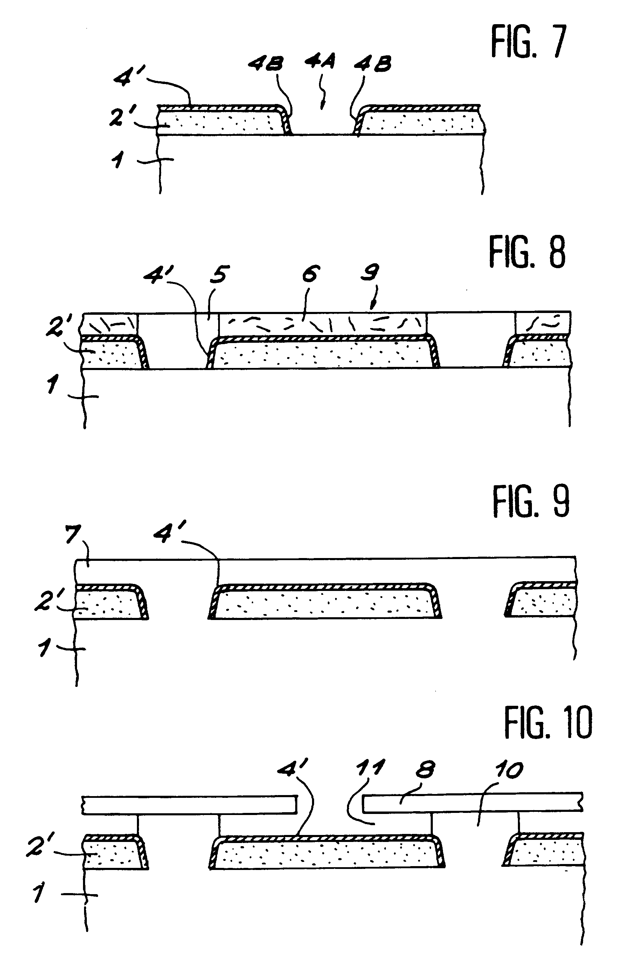

On part d'un substrat 1 de silicium (100) monocristallin en forme de disque d'un diamètre d'environ 100 à 130 mm (voir figure 4).
A1 : on dépose sur ce substrat 1, par pulvérisation cathodique réactive par exemple, ou par toute autre méthode connue de l'homme de l'art, une couche mince 2' de zircone stabilisée à l'oxyde d'yttrium ayant une épaisseur typique de quelques centaines de nm (quelques milliers d'Angstroems). Cette couche de zircone stabilisée est polycristalline, avec des grains ayant une taille typiquement du même ordre de grandeur que l'épaisseur de la couche 2.
A2 : on effectue après ce dépôt un recuit sous atmosphère d'oxygène, typiquement à 1000°C pendant quelques minutes, afin de stabiliser la composition de la couche de zircone et l'interface substrat/zircone.
A3 : on grave, par les méthodes connues de l'homme de l'art (plasma CF₄+He par exemple), dans la couche de zircone stabilisée, des zones 2A de germination. Selon un mode de réalisation avantageux, ces zones de germination sont des bandes parallèles ayant une largeur de 1 à 5 micromètres environ. Cette gravure met à nu des zones de germination qui vont permettre la recristallisation ultérieure ou la croissance épitaxiale latérale de la couche mince supérieure de silicium (couche 3 de la figure 3). L'intervalle entre deux bandes peut varier entre quelques dizaines et quelques centaines de micromètres, selon la méthode choisie de formation de la couche 3.
A4 : on dépose sur l'ensemble précédent une couche 4 continue de silicium amorphe d'une épaisseur d'environ 50 Angstroems (voir figure 6). Ce dépôt est avantageusement réalisé par CVD ("Chemical Vapor Deposition"), à une température d'environ 400°C, en utilisant du silane (SiH₄). De telles conditions sont optimales pour l'obtention d'une couche de silicium amorphe continue et de rugosité pratiquement nulle sur un substrat de zircone yttriée, comme on le voit d'après la figure 5. Sur cette figure 5, on a représenté les variations de l'épaisseur d'une couche de silicium amorphe obtenue à partir de silane en fonction du temps de dépôt pour trois températures de dépôt différentes (températures de 400,500 et 600°C) pour lesquelles la rugosité de la couche de silicium est d'environ 0,25 et 50 nm respectivement). Ce procédé de déposition, dans les conditions précitées, est le seul actuellement connu qui permette d'obtenir des couches très minces (d'environ 5 nm) et continues. La structure obtenue à la fin de cette étape est représentée en figure 6.
A5 : on oxyde thermiquement la couche 4 de silicium amorphe de façon à obtenir un film continu 4' de silice. Cette oxydation peut se faire sous atmosphère d'oxygène ou de vapeur d'eau, à une température de 1000°C environ. Ce film de silice est un matériau amorphe à toutes températures, et il encapsule la surface du dépôt 2' de zircone stabilisée. Cette encapsulation est utile, car, la zircone stabilisée étant polycristalline et non amorphe, on veut éviter lors de la recristallisation ou de la croissance ultérieure de la couche mince supérieure de silicium (3) des phénomènes de cristallisation aléatoires et parasites du silicium sur les microcristaux de zircone.
A6 : on pratique dans la couche 4 de silice des ouvertures 4A en correspondance avec les zones 2A, mais en ayant soin de laisser les flancs 4B de la couche 4 masqués, afin de ne pas découvrir la couche de zircone 2', et éviter que des microcristaux de zircone, d'orientation aléatoire, ne viennent perturber la recristallisation ultérieure du silicium (voir figure 7).
A7 : on dépose en conditions d'épitaxie sélective du silicium monocristallin 5 sur les ouvertures 4A, c'est-à-dire sur le substrat 1 de silicium monocristallin. Au cours de cette étape, on dépose simultanément du silicium polycristallin 6 sur la silice 4 (voir par exemple la Demande de Brevet français 88 04437). On obtient alors la structure représentée en figure 8. On trouvera des détails de réalisation du procédé d'épitaxie sélective par APCVD ("Atmospheric pressure chemical vapor deposition") ou RPCVD ("Reduced pressure CVD") dans les articles publiés d'une part par BORLAND et DROWLEY dans "Solid State Technology, Août 1985, page 141, et d'autre part par KARAPIPERIS et Coll. dans "Proceedings of the MRS Meeting, Symposium on SOI", Boston, Décembre 1987.
   A partir de la structure ainsi obtenue et représentée en figure 8, on peut mettre en oeuvre plusieurs méthodes d'obtention d'une couche mince de silicium monocristallin sur la zircone stabilisée encapsulée par la silice.
A8-1 Première méthode : on encapsule le dépôt de silicium (5+6) à l'aide de Si0₂ ou de Si₃N₄ déposé par un procédé CVD haute température (type HTO pour "High Temperature Oxyde") et on le recristallise par fusion du matériau polycristallin à l'aide d'un faisceau laser ou d'un faisceau d'électrons. Le détail de ces techniques n'est pas décrit ici, car il est connu en soi d'après l'article de D. CHAPUIS et Coll. dans "ESPRIT'87 Achievments and Impact", Part 1, North Holland, 55, 1987.
   On obtient ainsi, après élimination de l'encapsulant des couches (5+6), une structure telle que représentée en figure 9, où la couche 7 est du silicium monocristallin. Les bandes de silicium monocristallin de la couche 7 au-dessus des bandes 2′ de zircone stabilisée peuvent atteindre des dimensions latérales de l'ordre de 50 micromètres sans sous-joints de grains, et de l'ordre de quelques centaines de micromètres si l'on tolère quelques uns de ces sous-joints de grains dans la couche monocristalline.
A8-2 Deuxième méthode : on encapsule, à l'aide de Si0₂ par exemple, le dépôt (5+6) obtenu lors de l'étape A7, on ouvre dans l'encapsulant 8 un réseau de bandes comparables à celles obtenues lors de l'étape A3, mais situées au-dessus de la partie centrale 9 de chaque dépôt 6 de silicium polycristallin, et à travers ces bandes, on attaque ce silicium polycristallin, de façon a mettre à nu les germes latéraux 10 de silicium monocristallin (ces germes 10 sont en fait des bandes de la couche 5 légèrement attaquées latéralement pour être entièrement débarrassées de silicium polycristallin de la couche 6, la séparation entre ces couches 5 et 6 n'étant pas très nette). On obtient alors la structure représentée en figure 10.

On effectue ensuite, par croissance latérale en phase vapeur, et en conditions d'épitaxie sélective, le remplissage des bandes 11 laissées vides par l'attaque du silicium polycristallin. Cette étape de procédé est décrite en détail dans les Demandes de Brevet français 88 04437 et 88 04438.

On obtient après élimination de l'encapsulant 8 une structure similaire à celle représenté en figure 9, l'extension latérale des bandes de silicium monocristallin sur la zircone stabilisée pouvant atteindre une centaine de micromètres.

Les modes de réalisation décrits ci-dessus à titre d'exemples se rapportent à l'utilisation du silicium, mais il est bien entendu que l'invention n'est pas limitée à ce matériau, et peut être mise en oeuvre, en particulier en ce qui concerne l'étape A8-2, avec des matériaux semi-conducteurs des groupes III-V (tels que GaAs, InP...) ou II-VI.

On va maintenant décrire une variante du procédé de l'invention, dite méthode SDB ("Silicon Direct Bonding"). Cette méthode est basée sur le principe de collage de deux substrats de silicium avec interposition d'un film isolant entre eux.

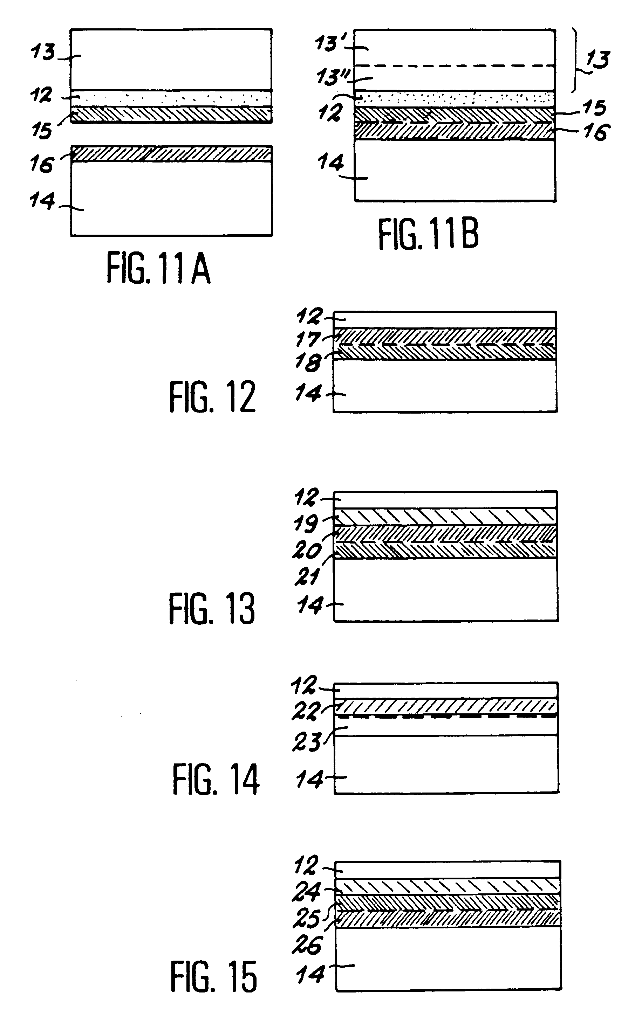

L'un des substrats se présente sous la forme d'une couche mince 12, de quelques micromètres d'épaisseur, de silicium monocristallin épitaxié sur un substrat 13 de silicium fortement dopé, d'orientation <100>. L'autre substrat 14, qui servira de support par la suite a une orientation et un dopage quelconques (voir figure 11A).
Etape B1 : on dépose, ou l'on forme par oxydation, sur l'un ou les deux substrats une couche de matériau "durcissant" ayant une épaisseur typique de quelques milliers d'Angstroems (10Å = 1nm). Dans l'exemple représenté sur la figure 11A, cette couche durcissante est formée sur les deux substrats. Celle formée sur la couche 12 du substrat 13 est référencée 15, et celle formée sur le substrat 14 est référencée 16.
Etape B2 : Après nettoyage de la surface isolante des deux pièces, pour éviter pratiquement toute contamination de ces surfaces, les surfaces durcies 15,16 des deux pièces sont plaquées l'une contre l'autre à la température ambiante. Les forces de Van der Waals sont suffisamment fortes entre les surfaces entre regard pour maintenir l'adhésion des substrats. Ensuite, la liaison intime des couches 15,16 est obtenue par un traitement thermique à haute température.
Etape B3 : Après collage, le substrat 13 est aminci mécaniquement, puis mécano-chimiquement jusqu'à une épaisseur d'environ 25 micromètres. Une attaque chimique dans une solution sélective termine l'amincissement jusqu'à l'interface Si fortement dopé (13)/Si épitaxié (12); l'attaque s'arrête automatiquement à cause de la différence de dopage. On obtient alors la structure de base de la figure 11B (semblable à celle de la figure 3) pour laquelle les parties éliminées ont été représentées en traits interrompus.

On va maintenant décrire en référence aux figures 12 à 15 diverses possibilités de réalisation des films isolants 15,16, qui sont en zircone yttriée (YSZ).
- Première méthode (figure 12). On dépose une couche mince (environ 1 micromètre) de YSZ 17,18 sur les deux substrats, ou éventuellement sur l'un d'eux, puis on applique l'une contre l'autre les couches 17,18 et on les colle par assemblage et recuit thermique. On élimine ensuite le substrat 13 ainsi que décrit en B3.
- Deuxième méthode (figure 13). On dépose successivement sur l'échantillon épitaxié (13+12) une couche mince de YSZ 19, puis une couche 20 de silicium amorphe ou de la silice obtenue par un processus a haute température (par cracking de silane dans N₂0 par exemple à 850°C environ) d'une épaisseur de quelques centaines à quelques milliers d'angstroems. Si l'on dépose, comme représenté en figure 13, du silicium amorphe, celui-ci est ensuite oxydé, de façon à obtenir une couche mince de silice (20). Le substrat 14 est ensuite superficiellement oxydé sur une épaisseur de quelques centaines à quelques milliers d'angstroems (couche 21 de silice) et ensuite, les deux structures supportées par les substrats 13 et 14 sont collées à haute température ainsi qu'indiqué a l'étape B2. Enfin, le substat 13 est éliminé selon l'étape B3, de façon à obtenir la structure finale de la figure 13.
- Troisième méthode (figure 14). C'est une variante de la deuxième méthode. Le substrat 14 est superficiellement oxydé (couche 23) et le collage (étape B2) est ensuite directement effectué sur la couche mince de zircone 22. On procède ensuite comme indiqué en B3 de façon à obtenir la structure de la figure 14.
- Quatrième méthode (figure 15). Après dépôt d'une couche 24 de YSZ sur le silicium épitaxié 12, on dépose de la silice colloïdale 25 par une méthode type "Spin on" par exemple, sur la couche de YSZ et sur le substrat support (couche 26). On procède ensuite au collage des deux échantillons, silice contre silice (étape B2) et à l'amincissement (étape B3).

## Revendications

1. Procédé de durcissement vis-à-vis des rayonnements ionisants de substrats pour composants électroniques actifs de grandes dimensions, caractérisé par le fait que l'on réalise leur structure de base en formant sur un substrat en silicium monocristallin (1) une couche (2) de zircone yttriée et que l'on forme sur cette couche de zircone yttriée une couche de silicium monocristallin (3).

2. Procédé selon la revendication 1, caractérisé par le fait que la zircone yttriée est obtenue par un procédé de dépôt en couche mince.

3. Procédé selon l'une quelconque des revendications précédentes, caractérisé par le fait que pour former la couche de silicium monocristallin, on grave dans la zircone des ouvertures mettant à nu des surfaces (2A) du substrat pour constituer des zones de germination, puis on forme un film continu de silice (4'), puis on pratique dans ce film de silice des ouvertures (4A) en correspondance avec celles pratiquées dans la zircone, et qu'on dépose du silicium monocristallin (5) dans les ouvertures (4A) ayant mis à nu le silicium monocristallin du substrat, et du silicium polycristallin (6) sur le film de silice, le silicium polycristallin étant soit recristallisé soit remplacé par une couche de silicium monocristalline épitaxiale.

4. Procédé selon la revendication 3, caractérisé par le fait que les ouvertures gravées dans la zircone sont sous forme de bandes parallèles d'une largeur d'environ 1 à 5 micromètres, l'intervalle entre ces bandes étant de quelques dizaines à quelques centaines de micromètres.

5. Procédé selon la revendication 3 ou 4, caractérisé par le fait que le film continu de silice est formé par dépôt d'une couche de silicium amorphe continue (4) qui est ensuite oxydée.

6. Procédé selon la revendication 5, caractérisé par le fait que la couche de silicium amorphe a une épaisseur d'environ 5 nm et est déposée à partir de silane à environ 400°C.

7. Procédé selon l'une des revendications 5 ou 6, caractérisé par le fait que la couche de silicium amorphe est oxydée thermiquement sous atmosphère d'oxygène ou de vapeur d'eau.

8. Procédé selon l'une des revendications 3 à 7, caractérisé par le fait que l'on dépose par épitaxie sélective le silicium monocristallin (5) et polycristallin (6).

9. Procédé selon l'une des revendications 3 à 8, caractérisé par le fait que l'on encapsule le dépôt de silicium mono et polycristallin et qu'on le recristallise par fusion du matériau polycristallin et qu'on élimine ensuite l'encapsulant.

10. Procédé selon l'une des revendications 3 à 8, caractérisé par le fait que l'on encapsule (8) le dépôt de silicium mono et polycristallin, que l'on pratique dans l'encapsulant des ouvertures situées dans la partie centrale de chaque dépôt de silicium polycristallin, que l'on attaque ce silicium polycristallin de façon à mettre à nu les germes latéraux de silicium monocristallin et que l'on effectue par croissance latérale en phase vapeur et en conditions d'épitaxie sélective le remplissage des zones laissées vides par l'attaque du silicium polycristallin.

11. Procédé selon la revendication 1, caractérisé par le fait que l'on forme sur un premier substrat (13) de silicium fortement dopé d'orientation 〈100〉 une mince couche de silicium monocristallin, que l'on dispose la couche de zircone yttriée (15, 16) sur la couche de silicium monocristallin déposée sur ce premier substrat et/ou sur un second substrat (14) de silicium d'orientation et de dopages quelconques, que l'on assemble ces deux pièces de façon que les substrats (13, 14) soient à l'extérieur et que l'on élimine ensuite le premier substrat.

12. Procédé selon la revendication 11, caractérisé par le fait que la couche de silicium monocristallin est déposée par épitaxie et a une épaisseur micronique ou submicronique.

13. Procédé selon l'une des revendications 11 ou 12, caractérisé par le fait que les deux pièces sont assemblées par collage à haute température.

14. Procédé selon l'une des revendications 11 à 13, caractérisé par le fait que le premier substrat est éliminé d'abord mécaniquement puis mécano-chimiquement et enfin chimiquement.

15. Procédé selon l'une quelconque des revendications 11 à 14, caractérisé par le fait que la zircone yttriée est déposée en couche mince (17, 18) d'environ 1 micromètre sur l'un au moins des deux substrats qui sont ensuite assemblés et collés par recuit thermique.

16. Procédé selon l'une quelconque des revendications 11 à 14, caractérisé par le fait que l'on dépose sur la couche mince de silicium monocristallin une couche mince de zircone yttriée (19 ou 22) puis une couche de silicium amorphe (20 ou 23).

17. Procédé selon la revendication 16, caractérisé par le fait que la couche de silicium amorphe est oxydée (20) ainsi que le deuxième substrat (21).

18. Procédé selon l'une quelconque des revendications 11 à 14, caractérisé par le fait que l'on dépose sur la couche mince de silicium monocristallin une couche mince de zircone yttriée (19) puis une couche de silice haute température (20), le deuxième substrat étant également oxydé (21).

19. Procédé selon l'une quelconque des revendications 11 à 14, caractérisé par le fait qu'après dépôt de zircone yttriée (24) sur la couche de silicium monocristallin (12), on dépose de la silice colloïdale sur les deux parties (25, 26).

20. Composants MOS ou bipolaires fabriqués sur des substrats de dimensions supérieures à environ 100 mm, durcis vis-à-vis des rayonnements ionisants, caractérisés par le fait que leur structure de base comporte successivement un substrat en silicium (1), une couche de zircone yttriée (2) résistant aux effets des rayonnements ionisants, et une couche (3) de silicium monocristallin.

## Claims

1. Process for hardening substrates for active electronic components of large dimensions against ionising radiations, characterised in that their basic structure is produced by forming on a substrate of monocrystalline silicon (1) a layer (2) of yttriated zirconia, and in that a layer of monocrystalline silicon (3) is formed on this layer of yttriated zirconia.

2. Process according to Claim 1, characterised in that the yttriated zirconia is obtained by a process of deposition in a thin layer.

3. Process according to either of the preceding claims, characterised in that in order to form the layer of monocrystalline silicon, openings are engraved in the zirconia, baring surfaces (2A) of the substrate to constitute nucleation zones, then a continuous film of silica (4') is formed, then there are made in this silica film openings (4A) corresponding to those made in the zirconia, and in that monocrystalline silicon (5) is deposited in the openings (4A) which have bared the monocrystalline silicon of the substrate, and polycrystalline silicon (6) on the silica film, the polycrystalline silicon either being recrystallised or replaced with an epitaxial monocrystalline layer of silicon.

4. Process according to Claim 3, characterised in that the openings engraved in the zirconia are in the form of parallel bands of a width of approximately 1 to 5 micrometres, the spacing between these bands being of a few tens to a few hundreds of micrometres.

5. Process according to Claim 3 or 4, characterised in that the continuous film of silica is formed by the deposition of a continuous layer of amorphous silicon (4) which is then oxidised.

6. Process according to Claim 5, characterised in that the layer of amorphous silicon has a thickness of approximately 5 nm and is deposited from silane at approximately 400°C.

7. Process according to either of Claims 5 and 6, characterised in that the layer of amorphous silicon is thermally oxidised under an atmosphere of oxygen or of water vapour.

8. Process according to one of Claims 3 to 7, characterised in that the monocrystalline (5) and polycrystalline (6) silicon is deposited by selective epitaxy.

9. Process according to one of Claims 3 to 8, characterised in that the deposit of mono- and polycrystalline silicon is encapsulated, and in that it is recrystallised by fusion of the polycrystalline material, and in that the encapsulating substance is then eliminated.

10. Process according to one of Claims 3 to 8, characterized in that the deposit of mono- and polycrystalline silicon is encapsulated (8), in that there are formed in the encapsulating substance openings situated in the central part of each deposit of polycrystalline silicon, in that this polycrystalline silicon is attacked in such a manner as to bare the lateral nuclei of monocrystalline silicon, and in that the filling of the zones left empty by the attack of the polycrystalline silicon is effected by lateral growth in the vapour phase and under conditions of selective epitaxy.

11. Process according to Claim 1, characterized in that there is formed on a first substrate (13) of highly doped silicon of orientation 〈100〉 a thin layer of monocrystalline silicon, in that the layer of yttriated zirconia (15,16) is disposed on the monocrystalline silicon layer deposited on this first substrate and/or on a second substrate (14) of silicon of any orientation and any dopings, and in that these two parts are assembled in such a manner that the substrates (13, 14) are on the outside, and in that the first substrate is then eliminated.

12. Process according to Claim 11, characterised in that the layer of monocrystalline silicon is deposited by epitaxy and has a micron or submicron thickness.

13. Process according to one of Claims 11 or 12, characterised in that the two parts are assembled by bonding at high temperature.

14. Process according to one of Claims 11 to 13, characterised in that the first substrate is eliminated first mechanically and then mechano-chemically and finally chemically.

15. Process according to any one of Claims 11 to 14, characterised in that the yttriated zirconia is deposited as a thin layer (17, 18) of approximately 1 micrometre on at least one of the two substrates which are then assembled and bonded by thermal annealing.

16. Process according to any one of Claims 11 to 14, characterized in that there are deposited on the thin layer of monocrystalline silicon a thin layer of yttriated zirconia (19 or 22) and then a layer of amorphous silicon (20 or 23).

17. Process according to Claim 16, characterised in that the layer of amorphous silicon is oxidised (20), as is the second substrate (21).

18. Process according to any one of Claims 11 to 14, characterised in that there is deposited on the thin layer of monocrystalline silicon a thin layer of yttriated zirconia (19) and then a layer of high-temperature silica (20), the second substrate being likewise oxidised (21).

19. Process according to any one of Claims 11 to 14, characterized in that after the deposit of yttriated zirconia (24) on the layer of monocrystalline silicon (12), colloidal silica is deposited on the two parts (25, 26).

20. MOS or bipolar components produced on substrates of dimensions exceeding approximately 100 mm, which are hardened against ionising radiations, characterised in that their basic structure comprises, in succession, a substrate of silicon (1), a layer of yttriated zirconia (2) resistant to the effects of ionising radiations, and a layer (3) of monocrystalline silicon.

## Patentansprüche

1. Verfahren zum Härten von Substraten für aktive elektronische Bauelemente mit großen Abmessungen gegenüber ionisierenden Strahlungen, dadurch gekennzeichnet, daß deren Grundstruktur durch Bilden einer Schicht (2) aus mit Yttriumoxid stabilisiertem Zirkonoxid auf einem Substrat aus monokristtallinem Silicium (1) verwirklicht wird und daß auf dieser Schicht aus mit Yttriumoxid stabilisiertem Zirkonoxid eine Schicht aus monokristallinem Silicium (3) gebildet wird.

2. Verfahren gemäß Anspruch 1, dadurch gekennzeichnet, daß das mit Yttriumoxid stabilisierte Zirkonoxid durch ein Dünnschicht-Ablagerungsverfahren erhalten wird.

3. Verfahren gemäß einem der vorangehenden Ansprüche, dadurch gekennzeichnet, daß zur Bildung der Schicht aus monokristallinem Silicium in das Zirkonoxid Öffnungen geätzt werden, wodurch Flächen (2A) des Substrats freigelegt werden, um Keimbildungszonen zu erzeugen, daß dann ein ununterbrochener Film aus Siliciumoxid (4') gebildet wird, daß dann in diesen Siliciumoxidfilm Öffnungen (4A) eingearbeitet werden, die mit den im Zirkonoxid eingearbeiteten Öffnungen in Übereinstimmung sind, und daß dann in die Öffnungen (4A), mit denen das monokristalline Silicium des Substrats freigelegt worden ist, monokristallines Silicium (5) und auf dem Siliciumoxidfilm polykristallines Silicium (6) abgelagert werden, wobei das polykristalline Silicium entweder rekristallisiert wird oder durch eine epitaktische, monokristalline Siliciumschicht ersetzt wird.

4. Verfahren gemäß Anspruch 3, dadurch gekennzeichnet, daß die in das Zirkonoxid geätzten Öffnungen die Form von parallelen Streifen mit einer Breite von ungefähr 1 bis 5 Mikrometern besitzen, wobei der Abstand zwischen diesen Streifen von einigen zehn bis zu einigen hundert Mikrometern reicht.

5. Verfahren gemäß Anspruch 3 oder 4, dadurch gekennzeichnet, daß der ununterbrochene Siliciumoxidfilm durch Ablagerung einer ununterbrochenen Schicht aus amorphem Silicium (4) gebildet wird, weiche anschließend oxidiert wird.

6. Verfahren gemäß Anspruch 5, dadurch gekennzeichnet, daß die Schicht aus amorphem Silicium eine Dicke von ungefähr 5 nm besitzt und aus Silan bei ungefähr 400°C abgeschieden wird.

7. Verfahren gemäß einem der Ansprüche 5 oder 6, dadurch gekennzeichnet, daß die Schicht aus amorphem Silicium in einer Sauerstoffatmosphäre oder in einer Wasserdampfatmosphäre thermisch oxidiert wird.

8. Verfahren gemäß einem der Ansprüche 3 bis 7, dadurch gekennzeichnet, daß das monokristalline Silicium (5) und das polykristalline Silicium (6) durch selektive Epitaxie abgelagert werden.

9. Verfahren gemäß einem der Ansprüche 3 bis 8, dadurch gekennzeichnet, daß die Ablagerung von mono- und von polykristallinem Silicium eingekapselt wird und daß sie durch Schmelzen des polykristallinen Materials rekristallisiert wird und daß anschließend die Einkapselung entfernt wird.

10. Verfahren gemäß einem der Ansprüche 3 bis 8, dadurch gekennzeichnet, daß die Ablagerung aus mono- und polykristallinem Silicium eingekapselt (8) wird, daß in die Einkapselung Öffnungen eingearbeitet werden, die sich im mittigen Teil einer jeden Ablagerung von polykristallinem Silicium befinden, daß dieses polykristalline Silicium bearbeitet wird, derart, daß die seitlichen Keime des monokristallinen Siliciums freigelegt werden, und daß das Auffüllen der durch die Bearbeitung des polykristallinen Siliciums leer gelassenen Zonen durch seitliches Wachstum in der Dampfphase und unter Bedingungen einer selektiven Epitaxie bewerkstelligt wird.

11. Verfahren gemäß Anspruch 1, dadurch gekennzeichnet, daß auf einem ersten Substrat (13) aus stark dotiertem Silicium mit der Orientierung 〈100〉 eine Dünnschicht aus monokristallinem Silicium ausgebildet wird, daß auf der Schicht aus monokristallinem Silicium, die auf diesem ersten Substrat und/oder auf einem zweiten Substrat (14) aus Silicium mit beliebiger Orientierung und beliebiger Dotierung abgelagert ist, die Schicht (15, 16) aus mit Yttriumoxid stabilisiertem Zirkonoxid abgelagert wird, daß diese beiden Teile zusammengefügt werden, derart, daß sich die Substrate (13, 14) außen befinden, und daß anschließend das erste Substrat entfernt wird.

12. Verfahren gemäß Anspruch 11, dadurch gekennzeichnet, daß die Schicht aus monokristallinem Silicium epitaktisch abgelagert wird und eine Dicke im Mikrometer- oder Submikrometerbereich besitzt.

13. Verfahren gemäß einem der Ansprüche 11 oder 12, dadurch gekennzeichnet, daß die beiden Teile durch Kleben bei hoher Temperatur zusammengefügt werden.

14. Verfahren gemäß einem der Ansprüche 11 bis 13, dadurch gekennzeichnet, daß das erste Substrat zunächst mechanisch und dann mechanisch-chemisch und schließlich chemisch entfernt wird.

15. Verfahren gemäß einem der Ansprüche 11 bis 14, dadurch gekennzeichnet, daß das mit Yttriumoxid stabilisierte Zirkonoxid als Dünnschicht (17, 18) von ungefähr 1 Mikrometer auf wenigstens einem von zwei Substraten abgelagert wird, welche anschließend zusammengefügt und durch thermisches Glühen zusammengeklebt werden.

16. Verfahren gemäß einem der Ansprüche 11 bis 14, dadurch gekennzeichnet, daß auf der Dünnschicht aus monokristallinem Silicium eine Dünnschicht aus mit Yttriumoxid stabilisiertem Zirkonoxid (19 oder 22), dann eine Schicht aus amorphem Silicium (20 oder 23) abgelagert werden.

17. Verfahren gemäß Anspruch 16, dadurch gekennzeichnet, daß die Schicht aus amorphem Silicium ebenso wie das zweite Substrat (21) oxidiert (20) wird.

18. Verfahren gemäß einem der Ansprüche 11 bis 14, dadurch gekennzeichnet, daß auf der Dünnschicht aus monokristallinem Silicium eine Dünnschicht aus mit Yttriumoxid stabilisiertem Zirkonoxid (19), dann eine Schicht (20) aus Siliciumoxid bei hoher Temperatur abgelagert werden, wobei das zweite Substrat ebenfalls oxidiert (21) wird.

19. Verfahren gemäß einem der Ansprüche 11 bis 14, dadurch gekennzeichnet, daß nach der Ablagerung von mit Yttriumoxid stabilisiertem Zirkonoxid (24) auf der Schicht aus monokristallinem Silicium (12) auf den beiden Teilen (25, 26) kolloidales Siliciumoxid abgelagert wird.

20. MOS- oder bipolare Bauelemente, die auf Substraten hergestellt sind, deren Abmessungen größer als ungefähr 100 mm sind und die gegenüber ionisierenden Strahlungen gehärtet sind, dadurch gekennzeichnet, daß ihre Grundstruktur aufeinanderfolgend ein Siliciumsubstrat (1), eine Schicht aus mit Yttriumoxid stabilisiertem Zirkonoxid (2), das den Wirkungen der ionisierenden Strahlungen widersteht, und eine Schicht (3) aus monokristallinem Silicium umfaßt.
